# EUROPEAN PATENT SPECIFICATION

(11) **EP 2 132 213 B1**
(45) Date of publication and mention of the grant of the patent: **15.05.2013**
(21) Application number: 08716025.5
(22) Date of filing: 25.02.2008
(51) Int. Cl.: C07F 7/08, H01B 1/12, H01L 51/30

(54) **SILYLETHYNYLATED HETEROACENES AND ELECTRONIC DEVICES MADE THEREWITH**
SILYLETHYNYLIERTE HETEROACENE UND DAMIT HERGESTELLTE ELEKTRONISCHE VORRICHTUNGEN
HÉTÉROACÈNES SILYLÉTHYNYLÉS ET DISPOSITIFS ÉLECTRONIQUES FABRIQUÉS AVEC CEUX-CI

(30) Priority: 07.03.2007 EP 07004633; 12.03.2007 EP 07005029; 26.03.2007 EP 07006166
(43) Date of publication of application: 16.12.2009
(73) Proprietor: University of Kentucky Research Foundation, Lexington, KY 40506 (US)
(72) Inventor: ANTHONY, John, E., Lexington, KY 40509 (US)
(74) Representative: Derow, Stephan
(86) International application number: PCT/EP2008/001482
(87) International publication number: WO 2008/107089

(56) References cited:
- WO-A-2005/055248
- WO-A-2007/105473
- JP-A- 2007 067 262
- JP-A- 2007 299 852
- US-A1- 2008 042 127
- PAYNE, MARCIA M. ET AL: "Stable, Crystalline Acenedithiophenes with up to Seven Linearly Fused Rings" ORGANIC LETTERS , 6(19), 3325-3328 CODEN: ORLEF7; ISSN: 1523-7060, 2004, XP002478325 cited in the application
- PAYNE, MARCIA M. ET AL: "Organic Field-Effect Transistors from Solution-Deposited Functionalized Acenes with Mobilities as High as 1 cm2/V.cntdot.s" JOURNAL OF THE AMERICAN CHEMICAL SOCIETY , 127(14), 4986-4987 CODEN: JACSAT; ISSN: 0002-7863, 2005, XP002478326
- LLOYD, MATTHEW T. ET AL: "Efficient Solution-Processed Photovoltaic Cells Based on an Anthradithiophene/Fullerene Blend" JOURNAL OF THE AMERICAN CHEMICAL SOCIETY , 129(29), 9144-9149 CODEN: JACSAT; ISSN: 0002-7863, 2007, XP002478327
- DATABASE CA [Online] CHEMICAL ABSTRACTS SERVICE, COLUMBUS, OHIO, US; ANTHONY, JOHN E.: "Design aspects of functionalized organic semiconductors" XP002478328 retrieved from STN Database accession no. 148:226402 & PMSE PREPRINTS , 96, 234 CODEN: PPMRA9; ISSN: 1550-6703, 2007,

## Description

### Technical Field

The present invention relates generally to the field of organic semiconductors and, more particularly, to silylethynylated heteroacenes as well as to formulations and electronic devices made with these compounds.

### Background of the Invention

Display technology is expected to become a dominant sector of high-tech industry in the future. It is also expected that the flat panel display technology will be revolutionized by the use of organic semiconductors that will allow manufacture of cheap, flexible, lightweight, fully portable flat panel displays with no apparent limits to their size. It is predicted that due to the lower manufacturing cost, organic semiconductor based displays will eventually gain dominance over amorphous silicon based counterparts and the respective market share will grow to $1.6 billion by 2007. To realize these goals, however, significant breakthroughs will have to take place in. the area of organic semiconductor material and device processing.

Interest in organic thin film transistors (OTFTs) for possible use in displays, sensors and other large area electronic applications has been increasing rapidly. Best reported organic thin film transistor (OTFT) device performance rivals or exceeds that of hydrogenated amorphous silicon devices, and low OTFT process temperatures allow fabrication on a range of surfaces including cloth, paper or lower temperature polymeric substrates.

Organic semiconductors for use in OTFTs can be broadly divided into two groups as high and low mobility materials. High mobility materials have mobility > 0.1 cm²/V-s, usefully large carrier energy bandwidth (> 0.1 eV) and weak or sometimes absent temperature activation of mobility. To date, most high mobility organic semiconductors have been small molecule materials (with pentacene the most notable example) and most have been deposited by vacuum sublimation or from a solution precursor with a high-temperature (> 150° C) conversion step. Low mobility materials have mobility from about 10⁻⁵ - 10⁻¹ cm²/V-s, typically transport carriers by hopping, and have strong temperature activation of mobility. Most polymeric organic semiconductors fall into this group and many have the potential advantage that they can be deposited from solution.

To date, there have been few reports of low-temperature solution processed organic semiconductors with high mobility. In addition, even for low mobility materials, current solution deposition techniques have not demonstrated material structure, thickness and property control comparable to vacuum deposition techniques.

It was an aim of the present invention to provide new organic semiconductor compounds with advantageous properties, especially with relatively low OTFT process temperatures and relatively high mobility. Another aim of the present invention was to extend the pool of organic semiconductor compounds available to the person skilled in the art. Other aims of the present invention are immediately evident to the person skilled in the art from the following detailed description.

It was found that these aims can be achieved by providing novel silylethynylated heteroacenes as claimed in the present invention.

M. Payne, S. Odom, R. Parkin, J. Anthony, Org. Lett. 2004, Vol. 6, No. 19, p.3325-3328, discloses silylethynylated heteroacenes, but does not disclose compounds according to the present invention. Furthermore, silylethynylated heteroacenes are disclosed in WO 2005/055248 and M. Payne et al., J. Am. Chem. Soc. 2005, 127, 4986-4987, but these documents do not disclose compounds according to the present invention.

### Summary of the Invention

The present invention relates to compounds of formula I 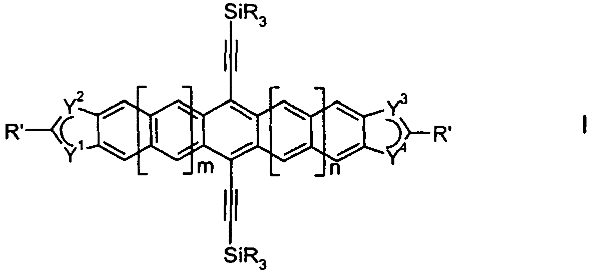 wherein
one of Y¹ and Y² denotes -CH= or =CH- and the other denotes -X-,
one of Y³ and Y⁴ denotes -CH= or =CH- and the other denotes -X-,
- X: is -O-, -S-, -Se- or -NR"'-,
- R: is cyclic, straight-chain or branched alkyl or alkoxy having 1 to 20, preferably 1 to 8 C-atoms, or aryl having 2-30 C-atoms, all of which are optionally fluorinated or perfluorinated, with SiR₃ preferably being trialkytsilyl,
- R': is H, F, Cl, Br, I, CN, straight-chain or branched alkyl or alkoxy having 1 to 20, preferably 1 to 8 C-atoms and optionally being fluorinated or perfluorinated, optionally fluorinated or perfluorinated aryl having 6 to 30 C-atoms, preferably C₆F₅, or CO₂R" with R" being H, optionally fluorinated alkyl having 1 to 20 C-atoms, or optionally fluorinated aryl having 2 to 30, preferably 5 to 20 C-atoms,
- R"': is H or cyclic, straight-chain or branched alkyl with 1 to 10 C-atoms, preferably H,
- m: is 0 or 1,
- n: is 0 or 1.

The invention further relates to a formulation comprising one or more compounds of formula I, and preferably further comprising one or more organic solvents.

The invention further relates to electronic devices, in particular transistors, organic field effect transistors (OFETs), organic thin film transistors (OTFTs), organic photovoltaic (OPV) devices, integrated circuits (ICs), sensors, radio frequency identification (RFID) tags and solar cells, comprising one or more compounds of formula I or formulations comprising them.

### Brief Description of the Drawings

The accompanying drawing incorporated in and forming a part of the specification, illustrates several aspects of the present invention and together with the description serves to explain certain principles of the invention. In the drawing:
**Figure 1a** and **1b** are schematical illustrations of two possible embodiments for the field-effect transistor of the present invention; and
**Figure 2a** and **2b** are schematical representations illustrating two possible embodiments of the photovoltaic apparatus of the present invention.

Reference will now be made in detail to the present preferred embodiments of the invention as illustrated in the accompanying drawing figures.

### Detailed Description of the Invention

The novel compounds of the present invention may be broadly described as silylethynylated heteroacenes (anthra(diheterocycles), tetra(diheterocycles) and penta(diheterocycles) compounds).

Preferred compounds of formula I are those wherein Y¹ = Y³ and Y² = Y⁴, and those wherein Y¹ = Y⁴ and Y² = Y³.

Preferred compounds of formula I are selected from the following formulae: 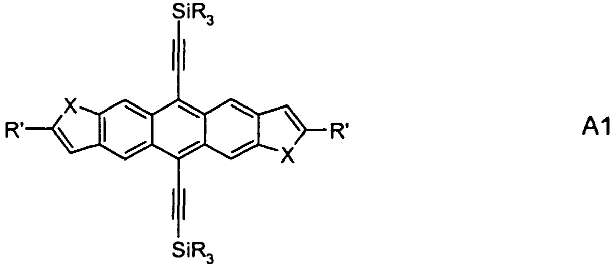 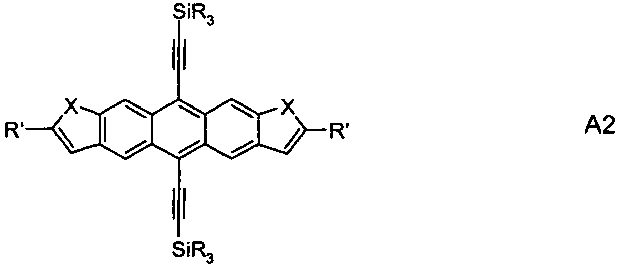 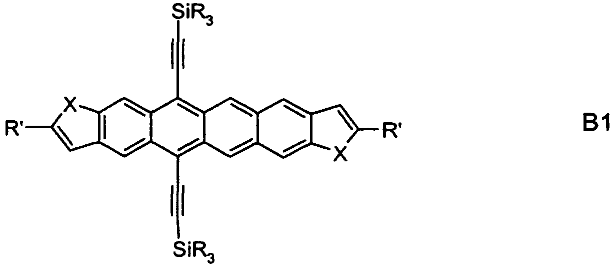 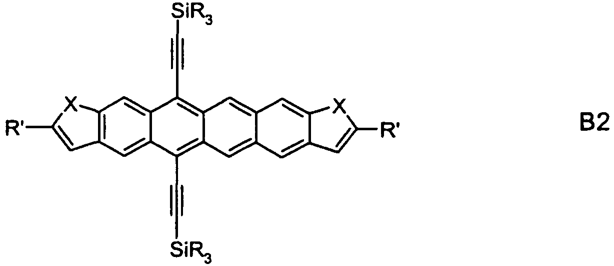 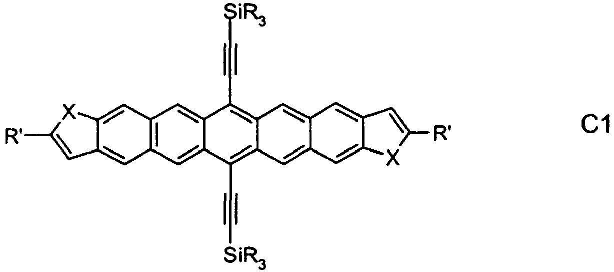 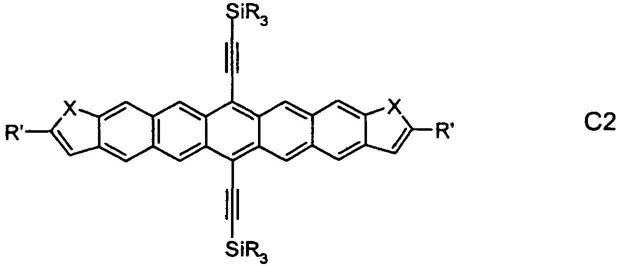 wherein R, R' and X are as defined above.

In accordance with yet another aspect of the present invention a formulation comprising one or more of the novel compounds of formula I, A1, A2, B1, B2, C1 or C2 and one or more solvents is provided. The solvents are preferably organic solvents, very preferably selected from alkylated and/or fluorinated or chlorinated benzenes like toluene, xylene and the like, anisole or its alkylated and/or fluorinated derivatives, tetralin, indane, decalin, N,N-dimethylaniline, N-methylpyrrolidone, N,N-dimethylformamide or pyridine.

In accordance with yet another aspect of the present invention a transistor is provided. The transistor preferably comprises a gate electrode, a semiconductor constructed from the novel compounds or formulations of the present invention, an insulator between the gate electrode and the semiconductor, a source electrode and a drain electrode.

In accordance with yet another aspect of the present invention, a photovoltaic device is provided. The photovoltaic device preferably comprises a transparent anode, a semiconductor constructed from the novel compounds or formulations of the present invention, an n-type material and a cathode.

Suitable methods and materials for preparing electronic devices like transistors and photovoltaic devices and their components, like for example the gate, source or drain electrode, cathode, anode or n-type material (electron transporter), are known to the person skilled in the art and are described in the literature, for example in WO 02/45184 A1, WO 03/052841 A1, WO 2004/013922 A2 and the references cited therein.

Very preferred are compounds of formulae I, A1, A2, B1, B2, C1 and C2 wherein
- X is -O-, -Se- or -NH-,
- X is -S-,
- R' is not H,
- R' is F, Cl, Br or COOH, very preferably F, Cl or Br, most preferably F,
- R is straight-chain or branched alkyl having 1 to 8 C atoms, preferably methyl, ethyl, propyl which is n-propyl or isopropyl, or butyl which is n-butyl, sec-butyl, isobutyl or tert-butyl,
- R"' is H,
- m=n=0,
- if X is S, then R' is not H,
- if m=n=0 and X is S, then R' is selected from optionally fluorinated or perfluorinated aryl having 6 to 30 C-atoms, preferably C₆F₅, F, Cl, Br, I, CN and CO₂R" very preferably from F, Cl and Br.

The silylethynylated heteroacenes are usually prepared as a mixture of isomers. Formula I thus covers isomer pairs wherein in the first isomer Y¹ = Y³ and Y² = Y⁴, and in the second isomer Y¹ = Y⁴ and Y² = Y³.

Formulae A₁ and A₂ represent the two isomers of anthra (diheterocycles). Formulae B₁ and B₂ represent the two isomers of tetra (diheterocycles). Formulae C₁ and C₂ represent the two isomers of penta (diheterocycles). The novel compounds of the present invention include both the mixture of the isomers of formulae A1, A2; B1, B2; or C1, C2 and the pure isomers A1, A2, B1, B2, C1 or C2.

The isomers A1, A2, B1, B2, C1 or C2 may be purified from the mixture of isomers of formulae A1, A2; B1, B2; or C1, C2 by methods known to those skilled in the art including but not limited to high-performance liquid chromatography (HPLC).

The novel compounds of the present invention can be prepared by a relatively simple and straightforward method. Specifically, the silylethynylated heteroacenes are easily made by the addition of an alkynyllithium to the corresponding acenequinone, followed by reductive workup with either HI or tin (II) chloride:

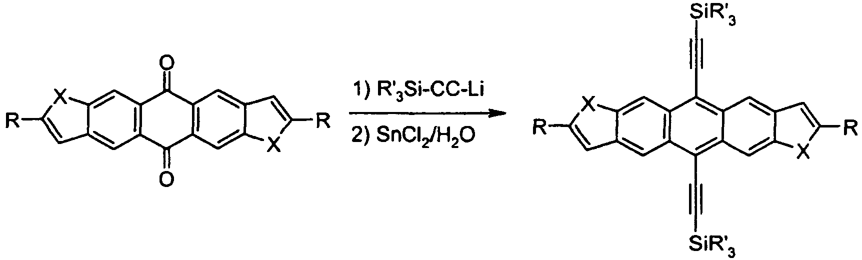

This type of reaction is well-described in:
Miller, G. P.; Mack, J.; Briggs, J. Org. Lett. 2000, 2, 3983,
Anthony, J, E,; Eaton, D. L.; Parkin, S. R. Org. Lett, 2002, 4, 15,
Anthony, J. E.; Brooks, J. S.; Eaton, D. L.; Parkin, S. J. Am. Chem, Soc. 2001, 123, 9482,
Payne, M M.; Odom, S. A.; Parkin, S. R.; Anthony, J. E. Org. Lett. 2004 6, 3325.

The acenequinone is very easily prepared by a 4-fold aldol condensation between a dialdehyde and commercially-available 1,4-cyclohexanedione:

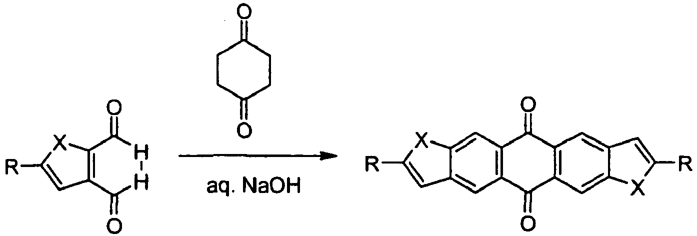

This condensation is well-described in;
De la Cruz, P.; Martin, N.; Miguel, F.; Seoane, C; Albert, A.; Cano, H.; Gonzalez, A.; Pingarron, J. M. J. Org. Chem. 1992, 57, 6192.

The "R" group of these dialdehydes is typically installed by the following sequence:

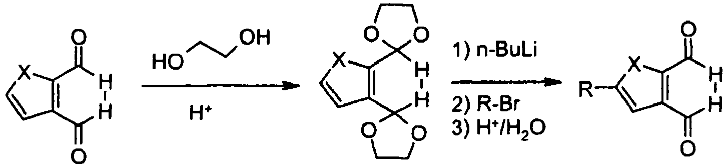

This procedure is described for thiophene dialdehyde in detail in: Laquindanura, J. G.; Katz, H. E.; Lovinger, A. J. J. Am. Chem. Soc. 1998, 120,664.

Compounds of the present invention wherein R' is halogen, e.g. F or Br, can be prepared according to or in analogy to reaction schemes 1 and 2:

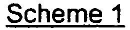

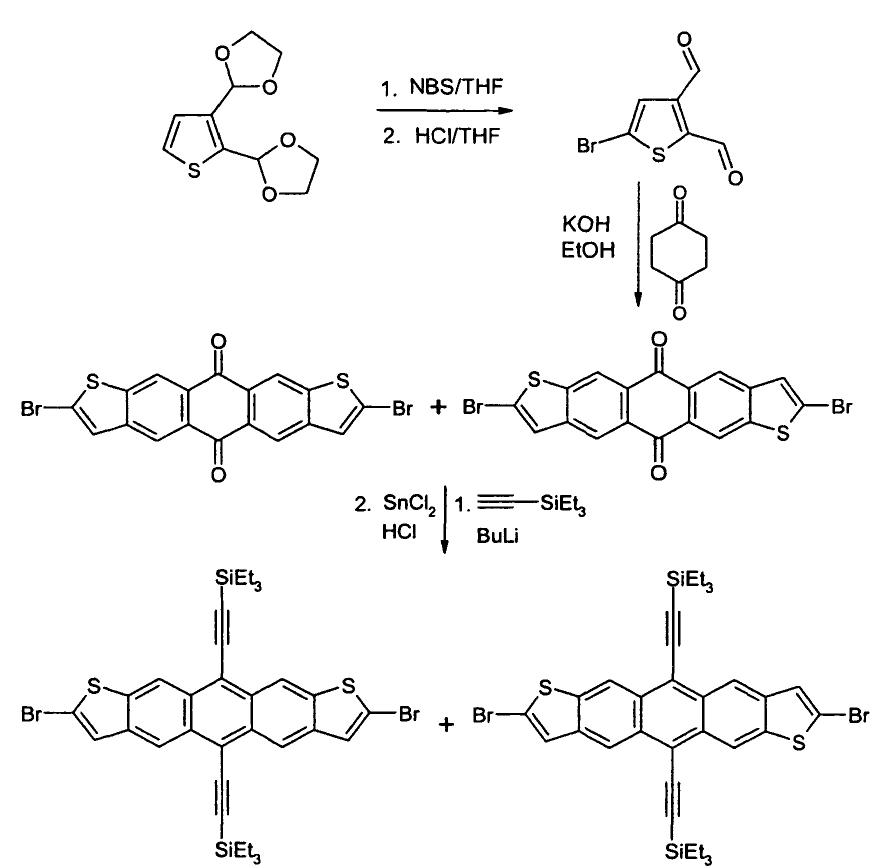

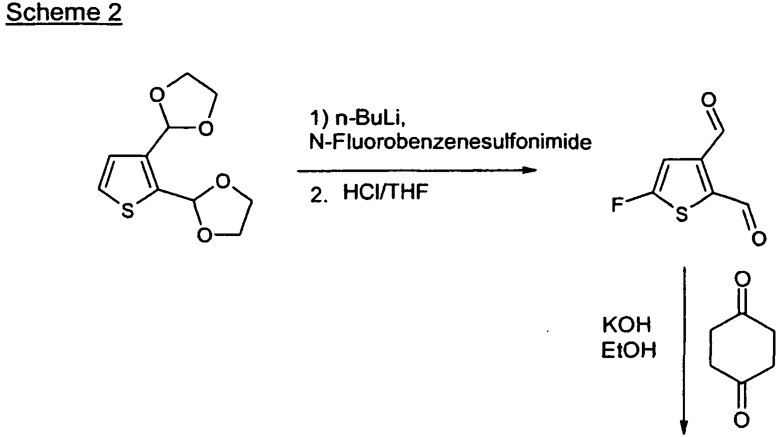

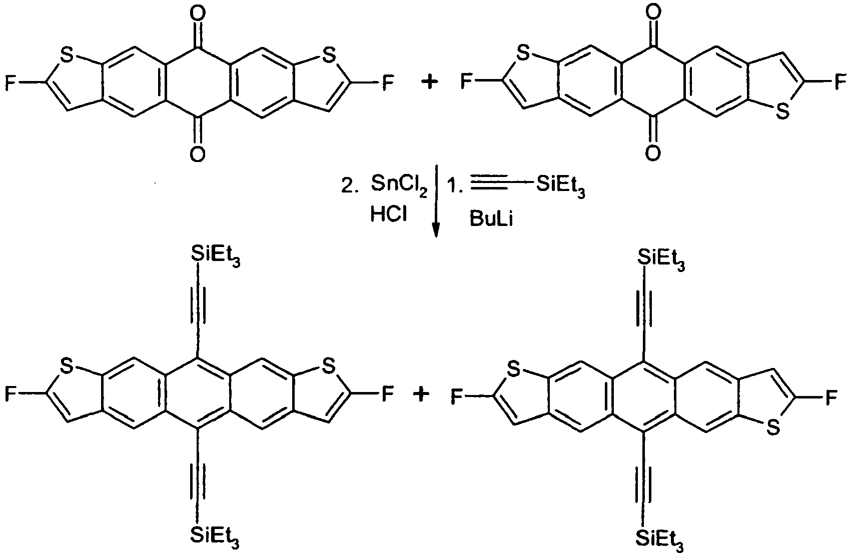

Thus the "base unit" for all of these materials is the heterocyclic dialdehyde. Many of these heterocyclic dialdehydes are known in the literature, and some are even commercially available:
Thiophene 2,3-dialdehyde is commercially available from Aldrich and Acros chemical.

Furan 2,3-dialdehyde is prepared as described in Zaluski, M. C; Robba, M.; Bonhomme, M. Bull. Chim. Soc. Fr. 1970, 4, 1445.

Selenophene 2,3-dialdehyde is prepared as described in Paulmier, C; Morel, J.; Pastour, P.; Scmard, D. Bull. Chim. Soc. Fr. 1969, 7, 2511.

Other heterocyclic dialdehydes can be prepared by the same methods outlined for the synthesis of the furan and selenophene compounds. The following synthesis and examples are prepared to further illustrate the invention, but it is not to be considered as limited thereto.

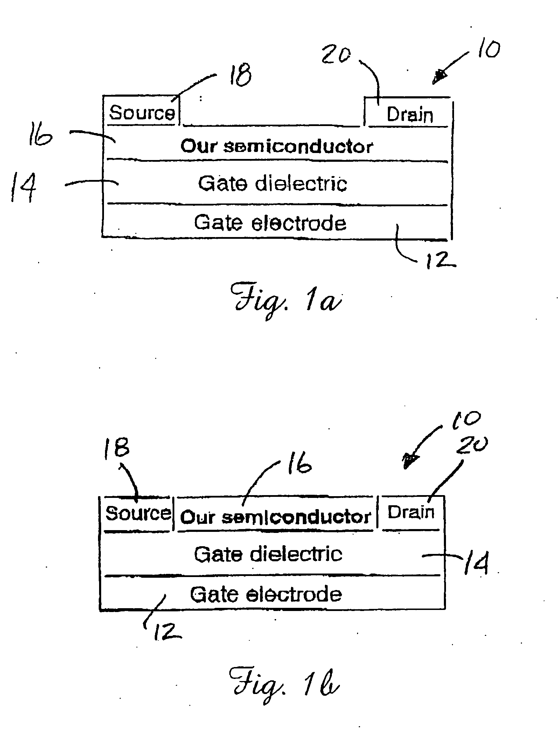

A number of useful electronic devices may be constructed from the novel compounds of the present invention. A typical field effect transistor (FET) according to the present invention (10) is illustrated in **Figure 1a****.** The FET (10) is comprised of a gate electrode (12) of a type known in the art, an insulator or gate dielectric (14) also of a type known in the art and a semiconductor (16) in the form of a thin layer or film of the compounds of the present invention. In addition, the FET (10) includes a conductive source electrode (18) and a drain electrode (20) both operatively connected to the semiconductor (16).

The insulator (14) may, for example, be a dielectric or metal oxide or even an insulating polymer like poly(methylmethacrylate). The conducting source and drain electrodes (18), (20) may be metals known in the art to be useful as electrodes, heavily doped semiconductors such as silicon or even a conducting polymer.

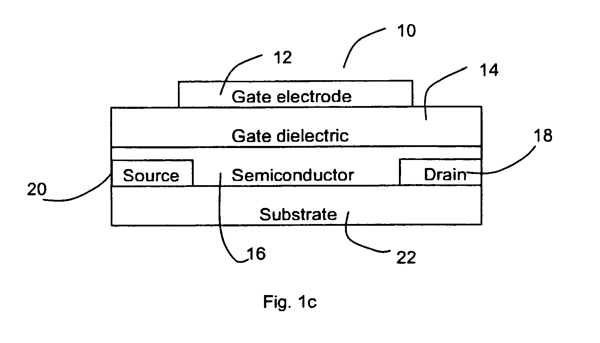

The FET illustrated in **Figure 1a** is known as a bottom-gate, top-contact configuration. An alternative embodiment of the FET (10) of the present invention is illustrated in **Figure 1****b.** This configuration is known as a bottom-gate, bottom-contact configuration.

Another alternative embodiment of the FET (10) of the present invention is illustrated in **Figure 1c****.** This configuration is known as a top-gate configuration, and is comprised of a substrate (22) of a type known in the art, a conductive source electrode (18) and a drain electrode (20), both operatively connected to a semiconductor (16) in the form of a thin layer or film of the compounds of the present invention, an insulator or gate dielectric (14) of a type known in the art, and a gate electrode (12) also of a type known in the art.

The gate electrode (12), source electrode (18) and drain electrode (20) may again be any sort of conductor: gold, silver, aluminum, platinum, heavily-doped silicon or an organic conducting polymer. The insulator or gate dielectric (14) can be an oxide such as aluminum oxide or silicone oxide or an insulating polymer such as poly(methylmethacrylate). In either configuration the compound of the present invention may be applied either by solution or vapor methods to form the semiconductor (16).

Optionally the semiconductor (16) comprises one or more organic binders, preferably polymeric binders, as described for example in WO 2005/055248 A1, to adjust the rheological properties, preferably in a proportion of binder to semiconductor from 20:1 to 1:20, preferably 10:1 to 1:10, more preferably 5:1 to 1:5 by weight. The binder polymers may also be semiconducting.

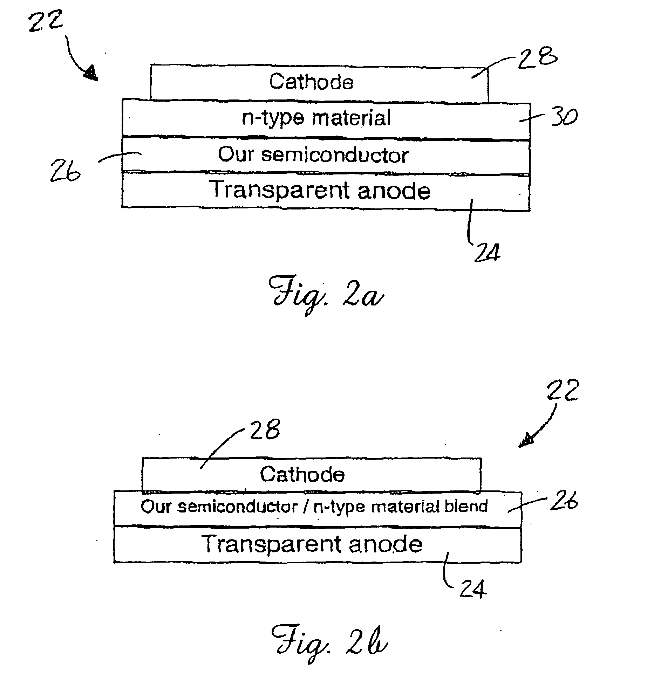

A typical photovoltaic apparatus according to the present invention (22) is illustrated in **Figure 2a****.** The photovoltaic apparatus (22) comprises a transparent conductive electrode or anode (24), a semiconductor (26) in the form of a thin layer or film of the compound of the present invention and a bottom electrode or cathode (28).

In the photovoltaic apparatus embodiment illustrated in **Figure 2a****,** a layer (30) of n-type material is provided between the semiconductor (26) and the cathode (28). In the photovoltaic apparatus (22) illustrated in **Figure 2b** the semiconductor (26) comprises the compound of the present invention blended with an n-type material.

In the case of organic solar cells, the compounds of the present invention are typically used as the hole transporter (the "p-type" material). This material must be used in conjunction (i.e. as a blend) with with an n-type material, defined as any electron-accepting compound. Suitable and preferred examples for n-type or acceptor materials are fullerenes like C60, or solubilized derivatives thereof, or perylene diimides like PTCBI (3,4,9,10-pery(enetetracarboxylic bisbenzimidazole).

The photovoltaic apparatus (22) can typically be constructed in the two ways illustrated in **Figures 2a** and **2b****.** As illustrated in **Figure 2a****,** the p-type compound and the n-type compound are both deposited from vapor or solution in sequential steps, leading to a single heterojunction interface. Alternatively, as illustrated in **Figure 2b****,** the p-type material and the n-type material may be mixed and deposited from solution on the anode prior to deposition of the cathode material. In this embodiment the p-type and n-type materials phase segregate, leading to multiple heterojunctions in the bulk. In both cases the anode material typically has a high work function and is transparent (ITO or (10) oxide on glass or plastic). In contrast, the cathode (28) is a low work function conductor, and is typically reflective to improve efficiency (aluminum, silver or an indium-gallium eutectic). In either case the anode layer can be pre-coated with a commercial conducting polymer like PEDOT (poly(3,4-ethylenedioxythiophene)) or a blend of PEDOT:PSS (poly(styrenesulfonate)) in order to improve charge injection efficiency.

The following examples are intended to explain the invention without restricting it. The methods, structures and properties described hereinafter can also be applied or transferred to materials that are claimed in this invention but not explicitly described in the foregoing specification or in the examples.

Unless stated otherwise, above and below percentages are per cent by weight and temperatures are given in degrees Celsius.

### Example 1

### 5,11-Bis(triethylsilylethynyl)anthra[2,3-b:6,7-b']dithiophene and 5,11-Bis(triethylsilylethynyl)anthra[2,3:-b:7,6-b']dithiophene.

To an oven-dried 250-mL round-bottom flask equipped with a stir bar and cooled under N₂ was added hexanes (20 ml) and 0.38 mL of triethylsilyl acetylene (2.0 mmol), followed by the dropwise addition of 0.73 ml of n-BuLi (1.8 mmol, 2.46 M solution in hexanes). This mixture was stirred for 1 h, then hexanes (80 ml) and anthradithiophenequinone (prepared by method described in De la Cruz, P. et al. J. Org. Chem. 1992, 57, 6192.) (0.16 g, 0.34 mmol) were added. The mixture was heated at 60° C overnight, then quenched with 0.5 mL of water. SnCl₂ ·2H₂O (0.50 g, 2.2 mmol) in 10 % aq. HCl (1 ml) was added and the mixture was stirred for 2 h at 60° C. The solution was dried over MgSO₄, then loaded onto a thick pad of silica. The silica was rinsed with hexanes (500 ml), then the product was eluted using hexanes: DCM (5:1). Removal of solvent yielded 0.18 g (0.31 mmol, 91 %) of a reddish powder. Recrystallization from hexanes yielded thick dark-red plates. Recrystallized 3x from hexanes. Yield: 91 %. MP: 151° C. ¹H-NMR (400 MHz, CDCl₃) δ = 9.18 (s,2H), 9.13 (s, 2H), 7.57 (d, J= 5.6 Hz, 2H, syn isomer), 7.57 (d, J = 5.2 Hz, 2H, anti isomer), 7.47 (d, J= 5.6 Hz, 2H), 1.27 (tt,J = 8.0 Hz, 1.6 Hz, 18H), 0.94 (q, J = 8.0 Hz, 1.2H). ¹³C-NMR (400 MHz, CDCl₃) δ = 140.27, 140.18, 1.39.82, 139.68, 133.70, 130.11 (2C), 130.01 (2C), 129.92 (2C), 129.81, 129.17, 123.95, 121.50, 121.44, 120.20, 118.05, 117.69,8.04 (2C), 7.82, 4.93 (2C), 4.50. Anal, calcd % C: 72.02, % H: 6.75. Found % C: 71.68, %H: 6.75.

For preparation of systems with alternative "R" groups, a different acetylene would be substituted for triethylsilyl acetylene in the above preparation. For preparation of systems where "R' " is different from "H" the requisite precursor quinones can be prepared as described in Laquindanum, J. G. et al., J. Am. Chem. Soc, 1998, 120, 664.

### Example 2

### Tetra[2,3-b:8,9-b']dithiophene-5,13-dione and Tetra[2,3 -b:9,8-b']dithiophene-5,13-dione.

A 1:2 mixture of 2,3-thiophenedicarboxaldehyde (0.85 g, 6.07 mmol) and benzo[1,2-b]thiophene-4,5-dicarboxaldehyde (1.66 g, 8.70 mmol) was dissolved in THF (200 ml) in a 500-ml round-bottom flask with a stir bar, then 1,4-cyclohexanedione (0.83 g, 7.40 mmol) was added and the solution was stirred until uniform. After the addition of 15 % KOH (2 ml), precipitate began to form immediately, and vigorous stirring was continued overnight. The solution was filtered to yield 3.87 g of a light brown powder made up of insoluble quinones which were used directly in the next step: MS (70 eV, EI) m/z 370 (100 %, M⁺).

### 5,13.Bis(tris(trimethylsilyl)silylethynyl)tetra[2,3.b:8,9.b']dithiophene and 5,13-Bis(tris(trimethylsilyl)si)ylethynyl)tetra[2,3-b:9,8-b']dithiophene.

To an oven-dried 500-mL round-bottom flask cooled under N2 and equipped with a stir bar was added hexanes (150 ml) and tris((trimethylsilyl)silyl acetylene (14 g, 51.1 mmol). n-BuLi (19.5 ml, 47,9 mmol, 2.6 M in hexanes) was added dropwise and the mixture was stirred for 2 hr. The above quinone mixture (3.87 g) was added and stirring was continued overnight, followed by the addition of anhydrous THF (20 ml) and additional stirring for 2 d. Water (2 ml) and a solution of SnCl₂-H₂O (10.0 g, 44 mmol) in 10 % HCl (20 ml) was added and the solution was stirred for 2 hr. DCM (100 ml) was then added and the organic layer was separated, dried over MgSO₄, and rinsed through a thin pad of silica (DCM). Solvent was concentrated to a volume of 10 ml, then diluted with hexanes (200 ml), and rinsed onto a thick pad of silica. The silica was rinsed with hexanes (600 ml), then hexanes: DCM (1:1) to elute the product mixture, and solvent was removed from this second fraction. Using column chromatography (hexanes:ethyl acetate (9:1)), 0.82 g of the desired tetradithiophene were isolated. The tetradithiophene was recrystallized from acetone to yield dark-blue needles. ¹H-NMR (400 MHz, CDCl₃) δ = 9.53 (s, 1 H), 9.45 (s, 1 H), 9.16 (s, 1H), 9.13 (s, 1 H), 8.53 (s, 1 H), 8.49 (s, 1 H), 7.54 (d, J = 5.6 Hz, 1H), 7.50 (d, J= 6.2 Hz, 1 H), 7.41 (s, 1H), 7.40 (s, 1H), 1.08 (s, 54H). ¹³C-NMR (400 MHz, CDC1³) δ = 140.49, 140.46, 140.20, 140.19, 139.92, 139.86,138.98,138.90, 130.27, 129.74, 129.61, 126.84,125.35,124.02,123.72,122.34,122.29,121.64, 121.04, 120.99, 120.29, 107.05, 106.72, 105.64, 104.85, 104.76, 11.5. UV-VIS (DCM): γ_{abs} (ε): 244 (18700), 300 (32400), 328 (61800), 372 (6940), 392 (5610), 465 (2110), 528 (766), 555 (1340), 599 (2810), 653 (4960). IR (KBr) νₘₐₓ (cm⁻¹): 2956 (m), 2945 (m), 2860 (s), 2129 (m), 1460 (m), 1400 (m), 1366 (s), 1061 (m), 997 (w), 882 (s),752 (s), 720 (vs), 661 (s), 586 (m).

### Example 3

### Penta[2,3-b:9,10-b']dithiophene-6,14-dione and Penta[2,3 -b:10,9-b]dithiophene-6,14-dione.

In a 500-mL round-bottom flask equipped with a stir bar, benzo[1,2-b]thiophene-4,5-dicarboxaldehyde (2.35 g, 12.4 mmol) was dissolved in THF (200 ml). 1,4-Cyclohexanedione (0.70 g, 6.2 mmol) was added and stirred until the solution was uniform, then 15 % KOH (2 ml) was added. Vigorous stirring was continued overnight, then the solution was filtered and rinsed with ether (20 ml) and DCM (20 ml). The brown solid was heated to reflux in DMF (400 ml) for 2 hr, then cooled and filtered to yield 1.6 g (3.8 mmol) of the desired quinone as a light brown insoluble powder. MS (70 eV, EI) m/z 420 (42 %, M⁺).

### 6,14- Bis(tri(t-butyl)silylethynyl)-penta[2,3-b:9,10-b']dithiophene and 6,14-Bis(tri(t-butyl)silylethynyl)-penta[2,5-b:10,9-b']dithiophene (6b).

To an oven-dried 250-ml round-bottom flask equipped with a stir bar and cooled under N₂ was added anhydrous THF (40 mL) and tri(t-butyl)silyl acetylene (3.59 g, 16,0 mmol). n-BuLi (5.7 ml, 14 mmol, 2.6 M in hexanes) was added dropwise and the solution was stirred for 1 hr, then the abovementioned quinone (1.6 g, 3,8 mmol) was added. After stirring for 24 hr, additional anhydrous THF (40 ml) was added and stirring was continued for 3 days. Water (2 ml) and a solution of SnCl₂ . H₂O (1.0 g, 4.4 mmol) in 10 % HCl (2 ml) was added and the solution was stirred for 2 hr. DCM (200 ml) was added and the organic layer was separated, dried over MgSO₄, and rinsed through a thin pad of silica (DCM). Solvent was concentrated to a volume of 10 ml then diluted with hexanes (200 ml). This solution was poured onto a thick pad of silica and rinsed with hexanes (500 ml), then hexanes:DCM (1:1) to elute the product. Removal of solvent yielded 0.44 g (0.53 mmol, 14 %) of product as a sparingly-soluble green powder. Recrystallization from toluene, then from CS₂ yielded 6b as slender dark green needles. ¹H-NMR (400 MHz, CDCl₃) δ = 9.49 (s, 2H), 9.41 (s, 2H), 8.41 (s, 2H), 8.38 (s, 2H), 7.46 (d, J - 5.6 Hz, 2H), 7.36 (s, J = 5.6 Hz, 2H), 1.50 (s, 54H). ¹³C-NMR (400 MHz, CS²/C₆D₆) δ = 140.52, 138.91, 130,98, 130.86, 130.67, 130.55, 129.57, 128.92, 128.88, 128.78, 128.75, 128.26, 127.96,127.94,127.59,126.11,124.08,122.94, 121.61, 109.10, 106.70,97.94,31.12, 30.81,28.89,22.73. UV-VIS (DCM): λ_{abs}, (ε): 277 (42500), 342 (69500), 373 (6350), 398 (2770),416 (2740),441 (2220), 475 (1730), 577 (145), 623 (474), 690 (1170),762 (2600). IR (KBr) νₘₐₓ (cm⁻¹): (cmol): 3400 (w), 2972 (m), 2935 (m), 2859 (5), 2133 (5), 1648 (w), 1385 (s), 1115 (m), 1032 (w), 890 (s), 820 (s), 748 (s), 619 (s). Anal calcd for C₅₄H₆₆S₂Si₂ · H₂O % C: 75.99, % H: 8.03. Found % C: 75.61, %H: 7.93. MS (70 eV, EI) m/z 834 (100 %, M⁺), 777 (63 %, M⁺ -C₄H₉). MP: 268 ° C (dec).

### Example 4

### 2,8-Dibromo-5,11-bis(triethylsilylethynyl)anthra[2,3-b:6,7-b'] dithiophene and 2,8-dibromo-5,11-bis(triethylsilylethynyl)anthra[2,3-b:7,6-b']dithiophene

### Step 1: 5-bromo-thiophene-2,3-dicarbaldehyde.

2,3-Bis(1,3-dioxolan-2-yl)thiophene (13.51 g, 59.2 mmol) was dissolved in THF (200 ml), followed by the addition of N-bromosuccinimide (11.0 g, 61.2 mmol). This mixture was stirred in the absence of light overnight (∼15 h), then water ( 300 ml) was added and the product was extracted with ether (3 × 200 ml). The organic phases were combined and washed with sat. aq. NaHCO₃ solution and brine, then dried over Na₂SO₄. The solvent was removed under reduced pressure. The residue was dissolved in THF (150 ml) then 2N HCl solution (40 ml) was added. This mixture was heated at reflux for 1 h. After cooling to room temperature, the reaction mixture was poured into water (300 ml) and extracted with ether (3 × 200 ml). The extracts were combined and washed with sat. aq. NaHCO₃, water and brine, then dried over Na₂SO₄. The solvent was removed under reduced pressure. The residue was purified by column chromatography, eluting with petrol/ethyl acetate (10:0 to 7:3), to give a brown solid (1.43 g, 11%). ¹H NMR (300MHz, CDCl₃): δ(ppm) 10.38 (s, 1H, CHO), 10.26 (s, 1H, CHO), 7.60 (s, 1H, Ar-H); ¹³C NMR (75 MHz, CDCl₃): δ(ppm) 183.3, 181.4, 148.4, 143.6, 132.4, 123.9; MS (*m*/*e*): 220 (M⁺), 218 (M⁺), 191,189, 161,163, 111, 82, 57, 39.

### Step 2: 2,8-dibromoanthra[2,3-b:6,7-b']dithiophene-5,11-dione and 2,8-dibromoanthra[2,3-b:7,6-b']dithiophene-5,11-dione.

5-Bromo-thiophene-2,3-dicarboxaldehyde (0.91 g, 4.2 mmol) was dissolved in EtOH (150 ml), followed by the addition of 1,4-cyclohexane dione (0.24 g, 2.1 mmol). Upon addition of a 15 % KOH solution (5 ml) with strong stirring, a precipitate began to form immediately. The mixture was stirred for an additional hour. The precipitate was collected and washed with water and ethanol, then dried under vacuum to give yellow solid of low solubility (0.85 g, 86%). IR (cm⁻¹): 1668 (C=O), 1574, 1488, 1317, 1253.

### Step 3: 2,8-dibromo-5,11-bis(triethylsilylethynyl)anthra[2,3-b:6,7-b'] dithiophene and 2,8-dibromo-5,11-bis(triethylsilylethynyl)anthra(2,3-b:7,6-b']dithiophene.

To a solution of triethylsilylacetylene (1.20 g, 8.55 mmol) in dioxane (70 ml) was added BuLi (1.6 M in hexanes, 5.3 ml, 8.48 mmol) dropwise at RT. This solution was stirred for 30 min, followed by the addition of 2,8-dibromoanthra[2,3-b:6,7-b']dithiophene-5,11-dione (0.80 g, 1.67 mmol). The resultant mixture was heated at reflux for 3 h. After cooling, solid SnCl₂ (5 g), then conc. HCl solution (10 ml) was added, and the mixture stirred for 30 min. The precipitate was collected by filtration and washed with water and acetone to give a deep purple solid, which was recystallized with acetone/THF, to give purple crystals (0.59 g, 49%). ¹H NMR (300MHz, CDCl₃): δ(ppm) 8.93 (m, 4H, Ar-H), 7.45 (s, 1H, Ar-H), 7.46 (s, 1H, Ar-H), 1.23 (m, 18H, CH₃), 0.91 (m, 12H, CH₂); ¹³C NMR (75 MHz, CDCl₃): δ(ppm) 140.7, 140.6, 139.8, 139.7, 130.0, 129.9, 129.6, 129.5, 126.4, 120.3, 120.2, 119.64, 119.59, 119.12, 119.06, 117.7, 107.3, 102.9, 7.85, 4.70; IR: 2126 cm⁻¹ (C≡C).

### Example 5

### 2,8-Difluoro-5,11-bis(triethylsilylethynyl)anthra[2,3-b:6,7-b'] dithiophene and 2,8-difluoro-5,11-bis(triethylsilylethynyl)anthra[2,3-b:7,6-b']dithiophene

The synthesis was carried out as described in example 4, but using the corresponding fluoro compounds instead of the bromo compounds.

¹H NMR (300MHz, CDCl₃): δ(ppm) 8.91 (s, 2H), 8.84 (s, 2H), 6.81 (d, 2H), 1.22 (m, 18H), 0.90 (m, 12H); ¹³C NMR (75 MHz, CDCl₃): δ(ppm) 167.83, 163.86, 136.66, 136.61, 136.57, 133.89, 130.14, 129.94, 129.58, 129.40, 120.80 (CH), 120.68 (CH), 120.59 (CH), 120.46 (CH), 120.36 (CH), 102.75 (CH), 102.60 (CH), 7.82 (CH3), 4.67 (CH2); IR: 2133 cm⁻¹ (C=C). MS (m/e): 602 (M⁺).

The compounds of the present invention demonstrate remarkable physical and electronic properties. The silyl acetylene unit substituted on the inner aromatic ring serves two important purposes. First it lends solubility to the molecule, allowing processing by simple, solution-based methods. Secondly and perhaps more importantly, this functional group causes the molecules to self-assemble into π-stacked arrays that are critical to improved device performance. More specifically, this molecular arrangement leads to improved conductivity, reduced band gap and field effect transistors (FETs) devices with a hole mobility of 0.001 to more than 1.0 cm²/Vs.

### Example 6

A field effect transistor as shown in **Figure 1a** was provided. The substrate for the field-effect transistor consisted of a heavily-doped Si wafer with thermally grown oxide layer (370 ran), serving as gate electrode and dielectric. Gold source and drain contacts were evaporated to yield devices with channel length of 22 µm and channel width of 340 µm. The gold electrodes were then treated with pentafluorobenzenethiol to improve the electrode interface. A 1 - 2 wt% solution of the triethylsilyl anthradithiophene derivative of Example 1 in toluene was spread across the device surface using a plastic blade, and the solvent allowed to evaporate. The devices were then heated in air at 90° C for two minutes to drive off residual solvent.

The triethylsilyl anthradithiophene derivative of Example 1 formed a uniform film of excellent quality yielding hole mobility of 1.0 cm²/Vs with excellent on/off current ratio (10⁷). The performance of this material is likely due to the close π-stacked interactions in the crystal. The triethylsilyl anthradithiophene derivative adopts a 2-D π-stacking arrangement with a π-face separation of approximately 3.25 A. The triethylsilyl anthradithiophene derivative was also characterized by a π-overlap of 1.57 A² and a lateral slip of 2.75, 1.76 A. All measurements were performed in air at room temperature and the mobility was calculated from the saturation currents.

### Example 7

A field effect transistor as shown in **Figure 1c** was provided as follows: On a glass substrate patterned Au source and drain electrodes were provided by shadow masking. A self assembling monolayer of pentafluorobenzenethiol (electrode injection layer) was spincoated onto the Au electrodes and washed with IPA. A semiconductor formulation was prepared by dissolving the difluoro triethylsilyl anthradithiophene derivative of Example 5 in a concentration of 2 wt.% in 4-methyl anisole. The semiconductor solution was then spincoated onto the substrate at 500 rpm for 18 seconds followed by 2000rpm for 60s at room temperature in air and the solvent was evaporated. The insulator material (Cytop® 809M, available from Asahi Glass) was mixed 3 parts to 2 parts of perfluorosolvent (FC75, Acros catalogue number 12380) and then spincoated onto the semiconductor giving a thickness of approximately 1 µm and the solvent was evaporated. A gold gate contact was defined over the device channel area by evaporation through a shadow mask

For the electrical measurements the transistor sample was mounted in a sample holder. Microprobe connections were made to the gate, drain and source electrodes using Karl Suss PH100 miniature probe-heads. These were linked to a Hewlett-Packard 4155B parameter analyser. The drain voltage was set to -5 V and the gate voltage was scanned from +20 to -60 V and back to +20 V in 1 V steps. The field effect mobility values were calculated from the gradient of the I_{SD} (source-drain current) vs. V_{G} (gate voltage) characteristic in the linear regime (Lin mob) and the saturation regime (Sat mob). All measurements were performed in air at room temperature. The results are summarized below:
Lin mob = 1.7 cm²/Vs
Sat mob = 2.2 cm²/Vs
On/Off ratio 10³

## Claims

1. Compounds of formula I 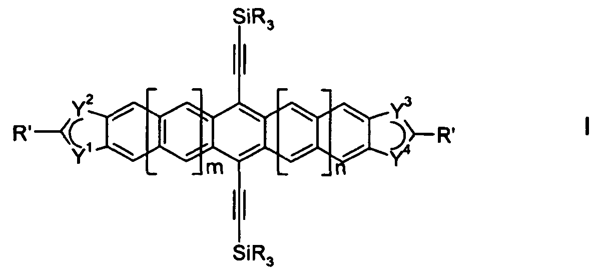 wherein
one of Y¹ and Y² denotes -CH= or =CH- and the other denotes -X-,
one of Y³ and Y⁴ denotes -CH= or =CH- and the other denotes -X-,
X is -O-, -S-, -Se- or -NR"'-,
R is cyclic, straight-chain or branched alkyl or alkoxy having 1 to 20 C-atoms, or aryl having 2-30 C-atoms, all of which are optionally fluorinated or perfluorinated,
R' is H, F, Cl, Br, I, CN, straight-chain or branched alkyl or alkoxy having 1 to 20 C-atoms and optionally being fluorinated or perfluorinated, optionally fluorinated or perfluorinated aryl having 6 to 30 C-atoms, or CO₂R" with R" being H, optionally fluorinated alkyl having 1 to 20 C-atoms, or optionally fluorinated aryl having 2 to 30 C-atoms,
R"' is H or cyclic, straight-chain or branched alkyl with 1 to 10 C-atoms,
m is 0 or 1,
n is 0 or 1
wherein the following provisos apply:
a) if X is S, then R' is not H;
b) if m = n = 0 and X is S, then R' is selected from fluorinated or perfluorinated aryl having 6 to 30 C-atoms, F, Cl, Br, I, CN and CO₂R".

2. Compounds of claim 1, selected from the following formulae: 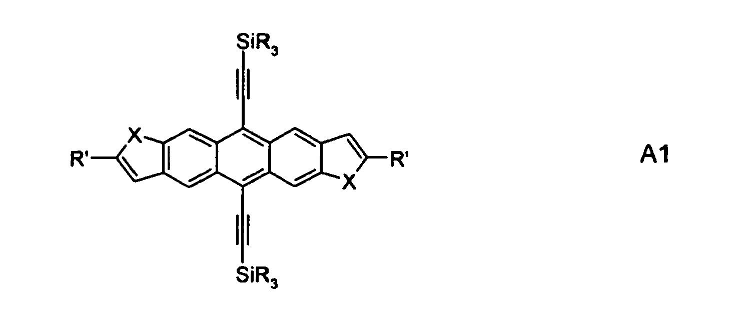 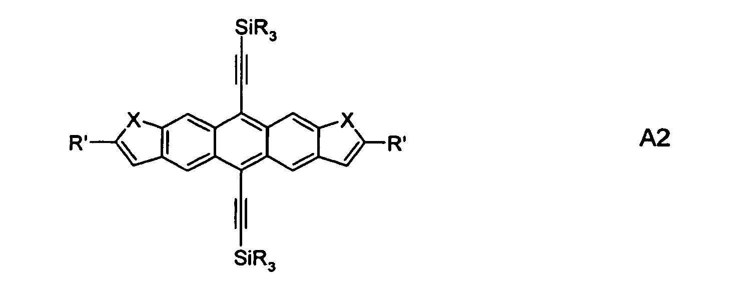 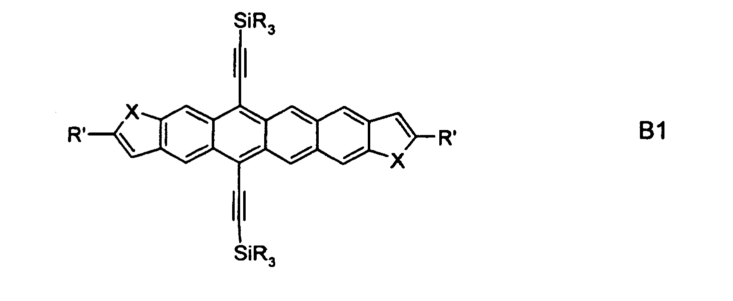 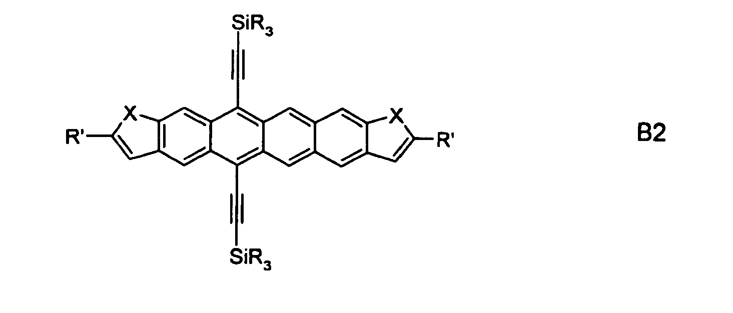 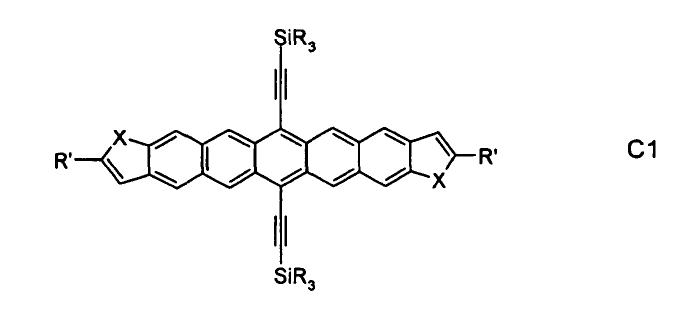 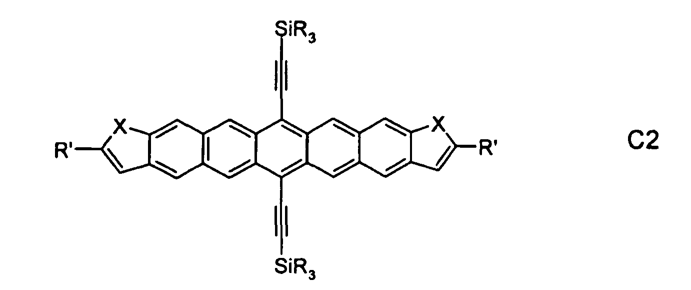 wherein R, R' and X are as defined in claim 1.

3. Compounds of claim 1 or 2, which are a mixture of isomers with the following formulae: 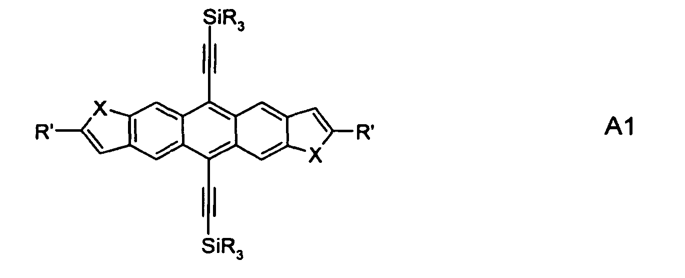 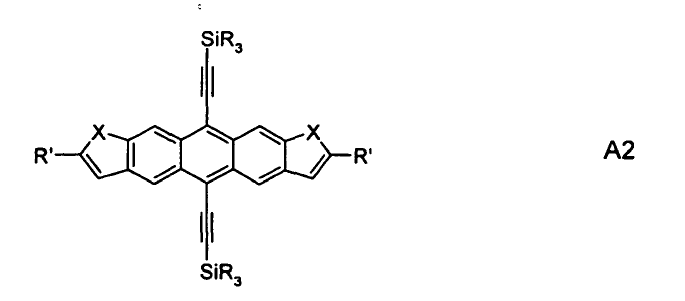 wherein R, R' and X are as defined in claim 1.

4. Compounds of claim 1 or 2, which are a mixture of isomers with the following formulae: 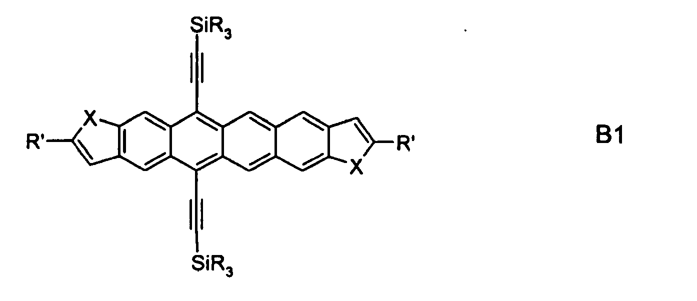 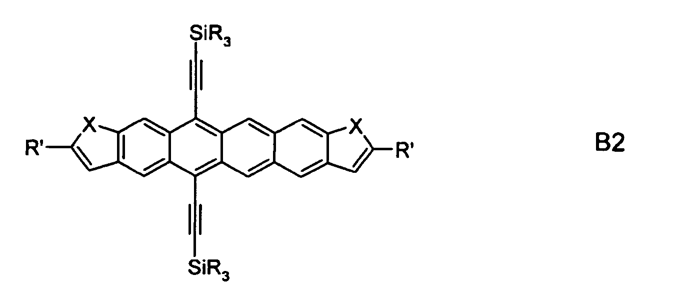 wherein R, R' and X are as defined in claim 1.

5. Compounds of claim 1 or 2, which are a mixture of isomers with the following formulae: 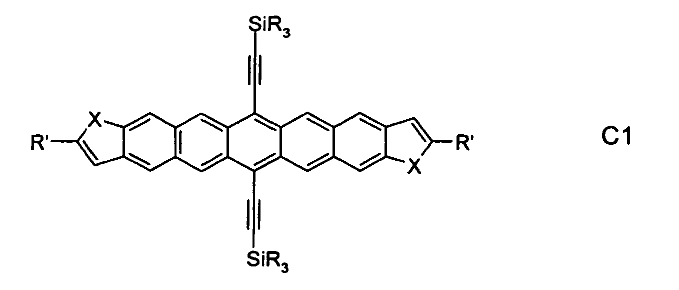 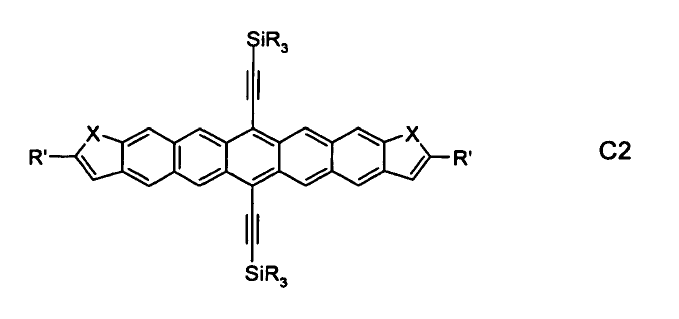 wherein R, R' and X are as defined in claim 1.

6. Compounds or mixtures of isomers according to one or more of claims 1 to 5, wherein R' is alkyl, perfluoroalkyl or alkoxy having 1-8 C-atoms, optionally fluorinated aryl having 5-30 C-atoms, F, Cl, Br, I, CN, CO₂R" or perfluoroaryl, with R" being H, C₁₋₂₀ alkyl or C₅₋₃₀ aryl.

7. A formulation comprising one or more compounds or mixtures of isomers according to one or more of claims 1 to 6, and further comprising one or more organic solvents.

8. An electronic device comprising one or more compounds, mixtures of isomers or formulations according to one or more of claims 1 to 7.

9. An electronic device according to claim 8, which is a transistor comprising:
a gate electrode;
a semiconductor comprising one or more compounds, mixtures or
formulations according to one or more of claims 1 to 7;
an insulator between said gate electrode and said semiconductor;
a source electrode; and
a drain electrode.

10. An electronic device according to claim 8, which is a photovoltaic apparatus comprising:
a transparent anode;
a semiconductor comprising one or more compounds, mixtures or
formulations according to one or more of claims 1 to 7;
an n-type material; and
a cathode.

## Patentansprüche

1. Verbindungen der Formel I 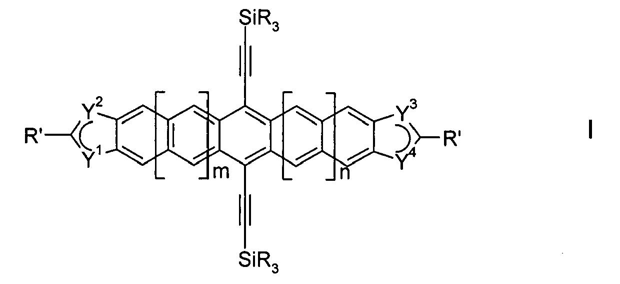 in der
eines von Y¹ und Y² -CH= oder =CH- und das andere -X- bedeutet,
eines von Y³ und Y⁴ -CH= oder =CH- und das andere -X- bedeutet,
X -O-, -S-, -Se- oder -NR"'- ist,
R cyclisches, geradkettiges oder verzweigtes Alkyl oder Alkoxy mit 1 bis 20 C-Atomen oder Aryl mit 2-30 C-Atomen ist, die jeweils gegebenenfalls fluoriert oder perfluoriert sind,
R' H, F, Cl, Br, I, CN, geradkettiges oder verzweigtes Alkyl oder Alkoxy mit 1 bis 20 C-Atomen, das gegebenenfalls fluoriert oder perfluoriert ist, gegebenenfalls fluoriertes oder perfluoriertes Aryl mit 6 bis 30 C-Atomen oder CO₂R" ist, wobei R" H, gegebenenfalls fluoriertes Alkyl mit 1 bis 20 C-Atomen oder gegebenenfalls fluoriertes Aryl mit 2 bis 30 C-Atomen ist,
R"' H oder cyclisches, geradkettiges oder verzweigtes Alkyl mit 1 bis 10 C-Atomen ist,
m 0 oder 1 ist,
n 0 oder 1 ist,
wobei die folgenden Maßgaben gelten:
a) wenn X S ist, dann ist R' nicht H;
b) wenn m = n = 0 und X S ist, dann ist R' aus fluoriertem oder perfluoriertem Aryl mit 6 bis 30 C-Atomen, F, Cl, Br, I, CN und CO₂R" ausgewählt.

2. Verbindungen nach Anspruch 1, die aus den folgenden Formeln ausgewählt sind: 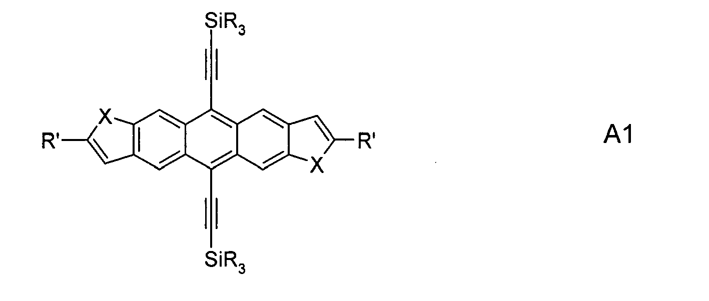 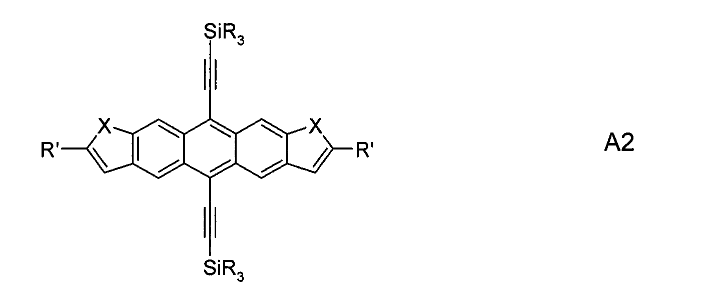 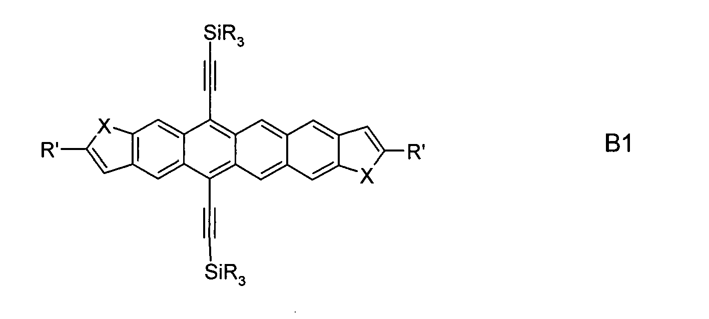 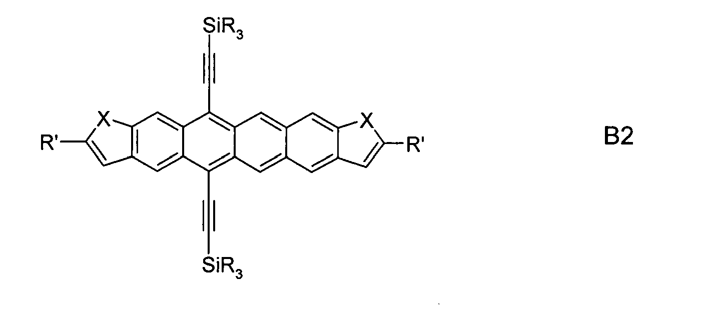 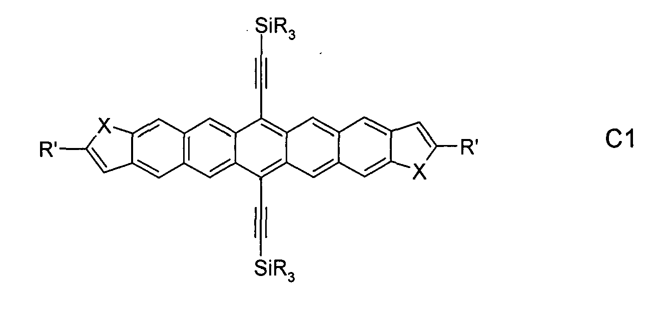 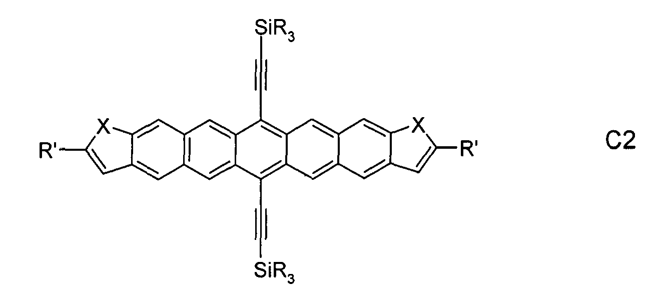 in denen R, R' und X wie in Anspruch 1 definiert sind.

3. Verbindungen nach Anspruch 1 oder 2, bei denen es sich um eine Mischung von Isomeren mit den folgenden Formeln handelt: 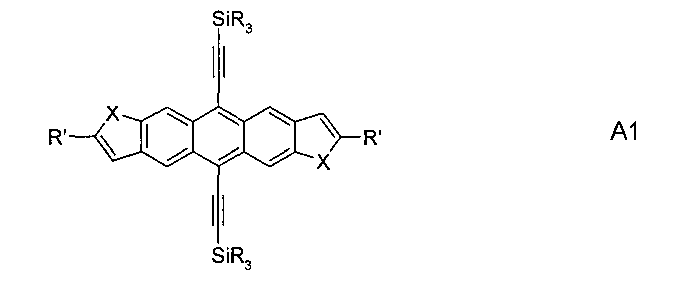 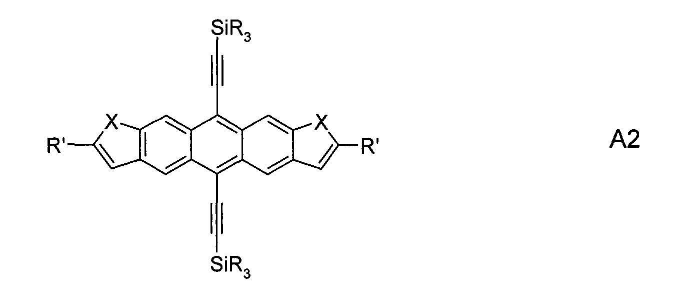 in denen R, R' und X wie in Anspruch 1 definiert sind.

4. Verbindungen nach Anspruch 1 oder 2, bei denen es sich um eine Mischung von Isomeren mit den folgenden Formeln handelt: 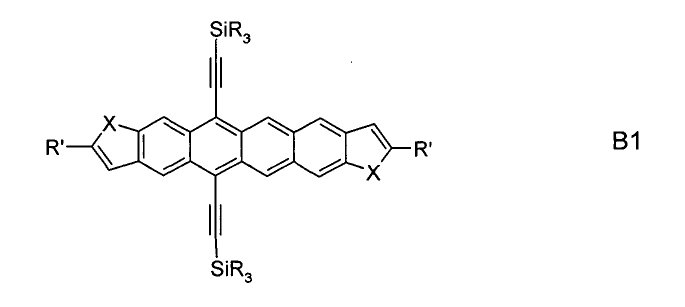 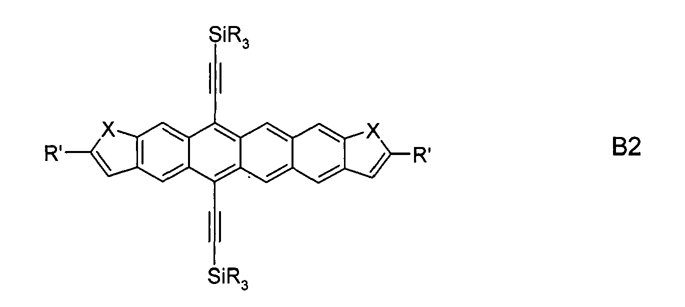 in denen R, R' und X wie in Anspruch 1 definiert sind.

5. Verbindungen nach Anspruch 1 oder 2, bei denen es sich um eine Mischung von Isomeren mit den folgenden Formeln handelt: 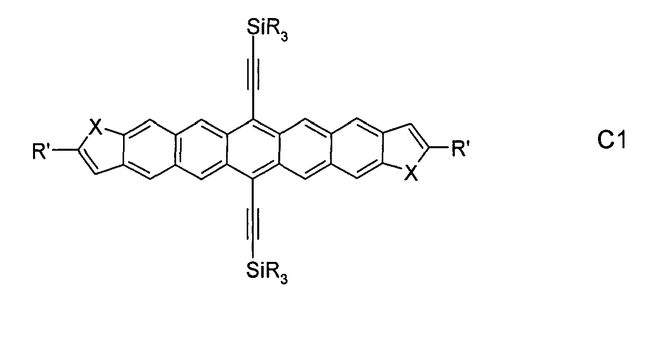 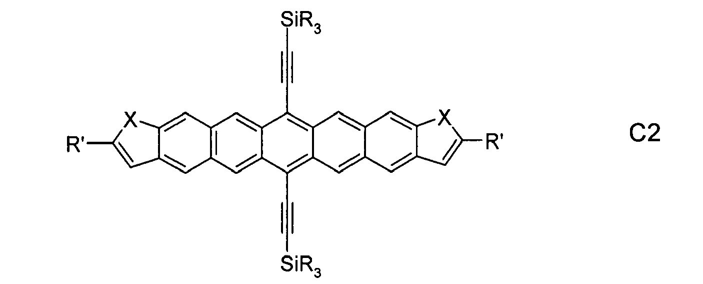 in denen R, R' und X wie in Anspruch 1 definiert sind.

6. Verbindungen oder Mischungen von Isomeren nach einem oder mehreren der Ansprüche 1 bis 5, in denen R' Alkyl, Perfluoralkyl oder Alkoxy mit 1-8 C-Atomen, gegebenenfalls fluoriertes Aryl mit 5-30 C-Atomen, F, Cl, Br, I, CN, CO₂R" oder Perfluoraryl ist, wobei R" H, C₁₋₂₀-Alkyl oder C₅₋₃₀-Aryl ist.

7. Formulierung, die eine oder mehrere Verbindungen oder Mischungen von Isomeren nach einem oder mehreren der Ansprüche 1 bis 6 und weiterhin ein oder mehrere organische Lösungsmittel enthält.

8. Elektronische Vorrichtung, die eine oder mehrere Verbindungen, Mischungen von Isomeren oder Formulierungen nach einem oder mehreren der Ansprüche 1 bis 7 enthält.

9. Elektronische Vorrichtung nach Anspruch 8, bei der es sich um einen Transistor mit:
einer Gate-Elektrode;
einem Halbleiter, der eine oder mehrere Verbindungen, Mischungen oder Formulierungen nach einem oder mehreren der Ansprüche 1 bis 7 enthält;
einem Isolator zwischen der Gate-Elektrode und dem Halbleiter;
einer Source-Elektrode und
einer Drain-Elektrode
handelt.

10. Elektronische Vorrichtung nach Anspruch 8, bei der es sich um ein photovoltaisches Gerät mit:
einer transparenten Anode;
einem Halbleiter, der eine oder mehrere Verbindungen, Mischungen oder Formulierungen nach einem oder mehreren der Ansprüche 1 bis 7 enthält;
einem Material des n-Typs und
einer Kathode
handelt.

## Revendications

1. Composés de la formule I 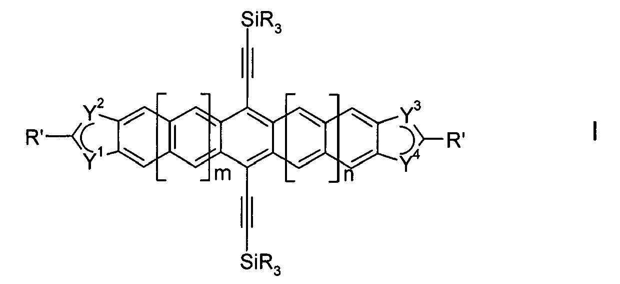 dans laquelle
l'un de Y¹ et Y² représente -CH= ou =CH- et l'autre représente -X-,
l'un de Y³ et Y⁴ représente -CH= ou =CH- et l'autre représente -X-,
X est -O-, -S-, -Se- ou -NR"'-,
R est alkyle ou alcoxy cyclique, en chaîne droite ou ramifié comportant de 1 à 20 atomes de C, ou aryle comportant 2-30 atomes de C, dont tous sont en option fluorés ou perfluorés,
R' est H, F, Cl, Br, I, CN, alkyle ou alcoxy en chaîne droite ou ramifié comportant de 1 à 20 atomes de C et en option fluoré ou perfluoré, aryle en option fluoré ou perfluoré comportant de 6 à 30 atomes de C, ou CO₂R" R" étant H, alkyle en option fluoré comportant de 1 à 20 atomes de C, ou aryle en option fluoré comportant de 2 à 30 atomes de C,
R"' est H ou alkyle cyclique, en chaîne droite ou ramifié avec de 1 à 10 atomes de C,
m est 0 ou 1,
n est 0 ou 1,
où ce qui suit s'applique :
a) si X est S, alors R' n'est pas H ;
b) si m = n = 0 et est S, alors R' est choisi parmi aryle fluoré ou perfluoré comportant de 6 à 30 atomes de C, F, Cl, Br, I, CN et CO₂R".

2. Composés de la revendication 1, choisis parmi les formules qui suivent : 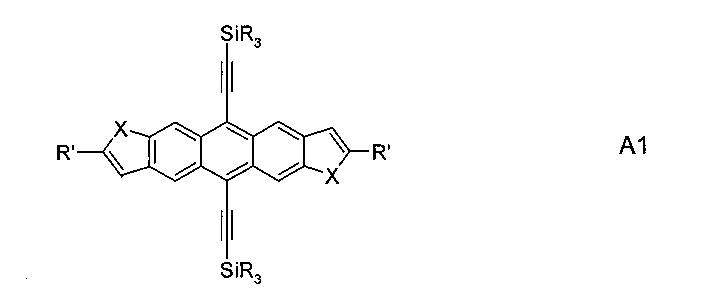 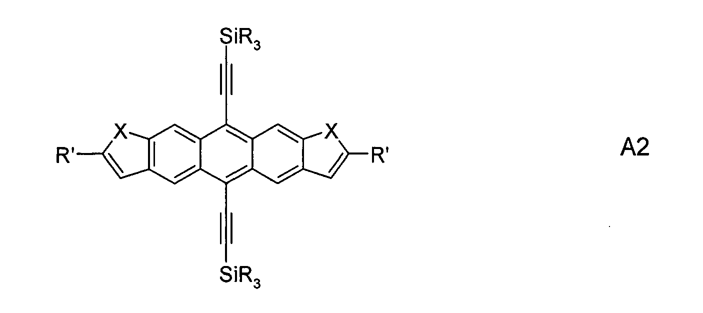 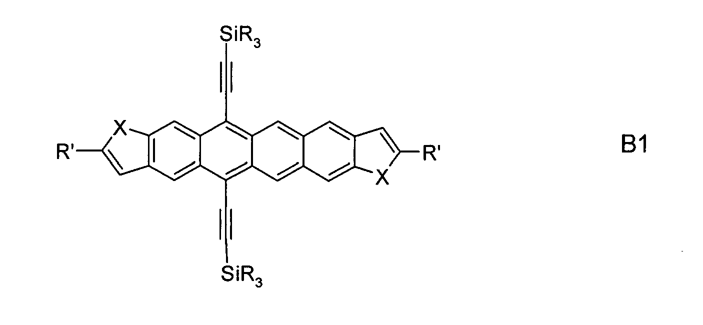 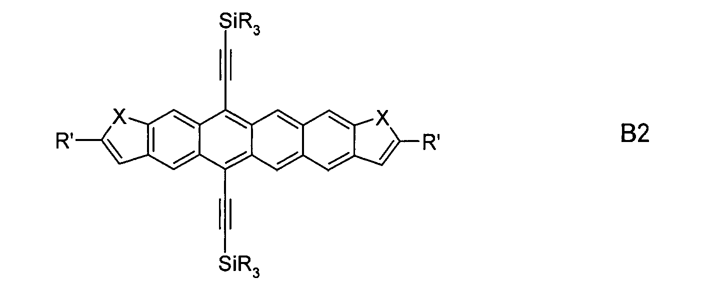 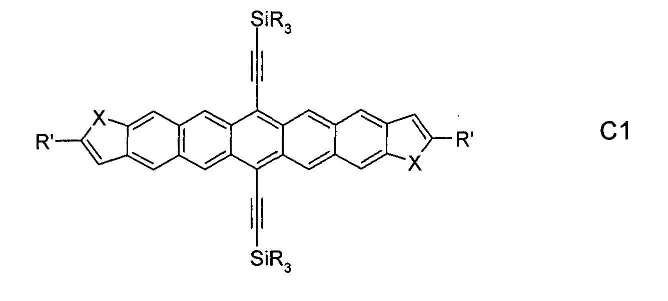 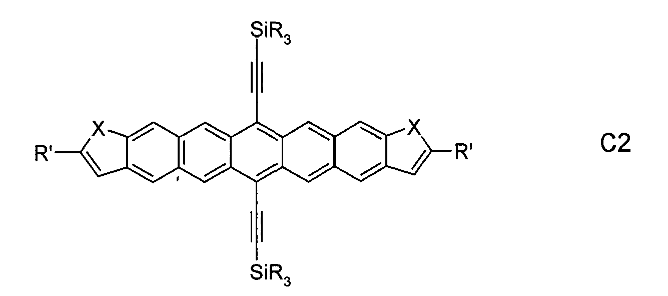 dans lesquelles R, R' et X sont comme défini selon la revendication 1.

3. Composés de la revendication 1 ou 2, lesquels sont un mélange d'isomères avec les formules qui suivent : 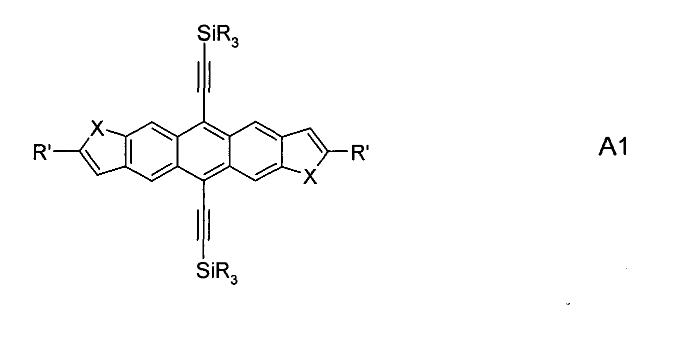 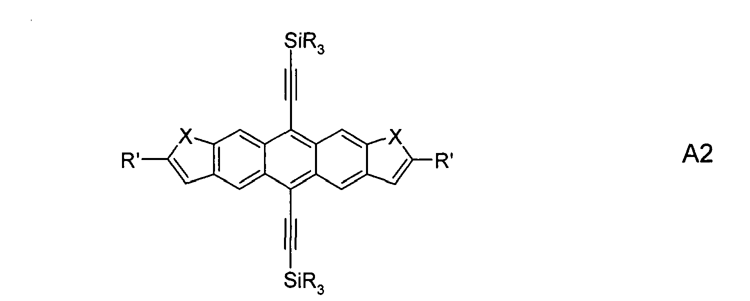 dans lesquelles R, R' et X sont comme défini selon la revendication 1.

4. Composés de la revendication 1 ou 2, lesquels sont un mélange d'isomères avec les formules qui suivent : 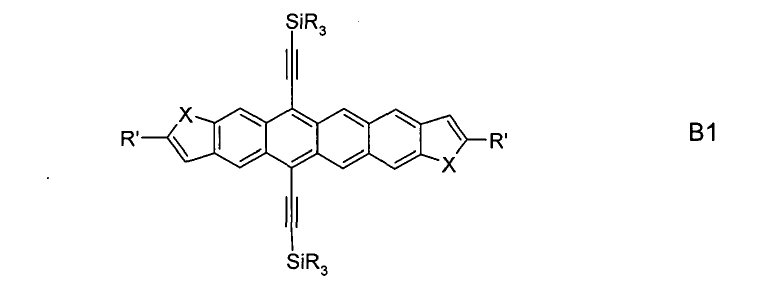 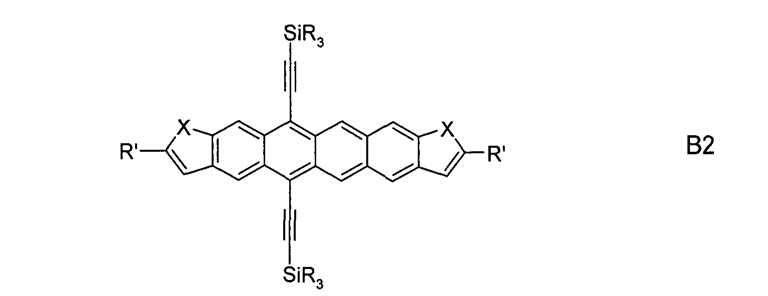 dans lesquelles R, R' et X sont comme défini selon la revendication 1.

5. Composés de la revendication 1 ou 2, lesquels sont un mélange d'isomères avec les formules qui suivent : 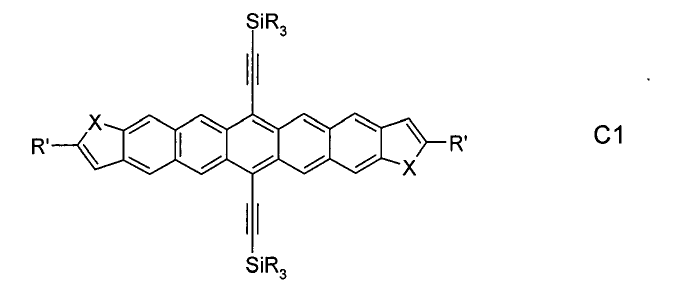 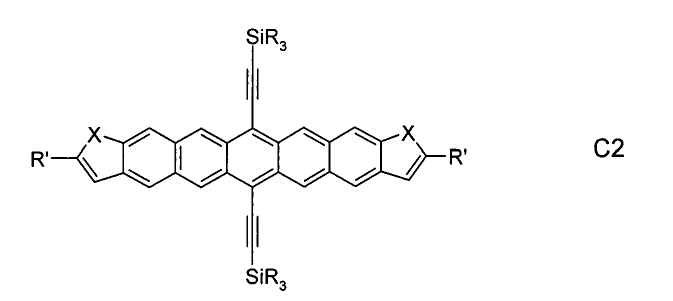 dans lesquelles R, R' et X sont comme défini selon la revendication 1.

6. Composés ou mélanges d'isomères selon une ou plusieurs des revendications 1 à 5, où R' est alkyle, perfluoroalkyle ou alcoxy comportant 1-8 atomes de C, aryle en option fluoré comportant 5-30 atomes de C, F, Cl, Br, I, CN, CO₂R" ou perfluoroaryle, R" étant H, C₁₋₂₀ alkyle ou C₅₋₃₀ aryle.

7. Formulation comprenant un ou plusieurs composés ou mélanges d'isomères selon une ou plusieurs des revendications 1 à 6, et comprenant en outre un ou plusieurs solvants organiques.

8. Dispositif électronique comprenant un ou plusieurs composés, mélanges d'isomères ou formulations selon une ou plusieurs des revendications 1 à 7.

9. Dispositif électronique selon la revendication 8, lequel est un transistor comprenant :
une électrode de grille ;
un semiconducteur comprenant un ou plusieurs composés, mélanges
ou formulations selon une ou plusieurs des revendications 1 à 7 ;
un insolant entre ladite électrode de grille et ledit semiconducteur ;
une électrode de source ; et
une électrode de drain.

10. Dispositif électronique selon la revendication 8, lequel est un appareil photovoltaïque comprenant :
une anode transparente ;
un semiconducteur comprenant un ou plusieurs composés, mélanges ou formulations selon une ou plusieurs des revendications 1 à 7 ;
un matériau de type n ; et
une cathode.
